(19)

Europäisches
Patentamt
European
Patent Office
Office européen
des brevets

(11) **EP 2 675 069 A1**

(12) **EUROPEAN PATENT APPLICATION**

(43) Date of publication:
**18.12.2013 Bulletin 2013/51**

(51) Int Cl.:
***H03M 13/37*** *(2006.01)*

(21) Application number: **12172196.3**

(22) Date of filing: **15.06.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicants:
• **Alcatel Lucent
75007 Paris (FR)**
• **INRIA
78153 Le Chesnay Cedex (FR)**

(72) Inventors:
• **Mattoussi, Ferdaouss
38000 Grenoble (FR)**
• **Sayadi, Bessem
91620 Nozay (FR)**
• **Roca, Vincent
38420 Domene (FR)**

(74) Representative: **Camus, Olivier Jean-Claude
Cabinet Camus Lebkiri
87, rue Taitbout
75009 Paris (FR)**

(54) **Method for encoding with GLDPC codes based on reed-solomon component codes**

(57) The present invention relates to a method of encoding for transmission of K source symbols ($S=(s_1,s_2,...,s_K)$) across a binary erasure channel (CH), said method comprising encoding said source symbols ($S=(s_1,s_2,...,s_K)$) by means of an encoder (ENC) connected to a transmitter device (TR), whereby encoding is performed by a (NG, K) Generalized Low-Density Parity-Check (GLDPC) using:

- A Low-Density Parity-Check (LDPC) code as a base code, and
- Reed-Solomon (RS) codes as component codes, wherein RS codes are based on a quasi-Hankel matrix of the form :

where $b_i = \dfrac{1}{1-y^i}$ .

**Fig. 1**

**Description**

FIELD OF THE INVENTION

The present invention relates to a method of data encoding and decoding for transmission across a binary erasure channel.

BACKGROUND

To improve error floor, minimal distance and decoding complexity performances, an extension of Low Density Parity Check (LDPC) codes has been suggested by Tanner in "A recursive approach to low complexity codes", IEEE Transactions on Information Theory, vol. 27, no. 5, pp. 533-547, Sept. 1981. These codes are named Generalized LDPC (GLDPC) codes. They are constructed by extending a LDPC code (named base code) through component codes.
An other construction of GLDPC using LDPC code as a base code and Reed Solomon (RS) codes as component codes has been proposed in "Low-rate coding using incremental redundancy for GLDPC codes", M. Cunche, IEEE International Workshop on Satellite and Space Communications, pp. 299-303, Oct. 2008.
This construction has a key benefit: in addition to the LDPC repair symbols, extra-repair symbols can be produced by the component codes on demand and in large quantities, a feature that is well suited to situations where the channel conditions can be worse than expected, or to fountain like content distribution applications.
The author writes:

*"Let the parameters of the RS code be (k+1+E, k). Thus, k is the number of information symbols (the code dimension), k+1+E is the number of coded symbols (the code length), and the number of repair symbols that can be generated by the code is equal to 1+E. Without losing generality, we may assume that the first repair symbol is the XOR sum of the k information symbols. Precisely, since the RS code is systematic, for any information symbols $(x_1,x_2,...,x_k)$, the repair symbols are computed as:*

$$(y_1, y_{1,1}, ..., y_{1,E}) = (x_1, ..., x_k)G'$$

*where G', a $k\times(1+E)$ matrix, is a sub-matrix of the systematic RS code associated to the repair symbols. The first repair symbol $y_1$ is the XOR sum of the source symbols $x_1,..., x_k$ if all the coefficients on the first column of G' are equal to 1. This can be obtained by multiplying the $k\times(1+E)$ sub-matrix (associated to the repair symbols), of a systematic RS generator matrix, at the left by an appropriate invertible matrix, which will change the way the encoding is done but not the MDS property of the code. "*

First, the author does not propose any implementation example of the matrix sub-matrix G'. Secondly, it is inexact that the Maximum Distance Separable (MDS) property of a code is guaranteed if G' is multiplied at the left by an invertible matrix. At last, as the RS code should be applied in a dynamic way, the matrix should be created repetitively on the sender and receiver: this consumes a lot of CPU.

SUMMARY

It is an object of the invention to provide a method for encoding with a GLDPC code based on Reed-Solomon component codes, which minimize the encoding time while guarantying a Maximum Distance Separable property.
To this end, there is provided a method of encoding for transmission of K source symbols across a binary erasure channel, said method comprising encoding said source symbols by means of an encoder connected to the transmitter device, whereby encoding is performed by a (NG, K) Generalized Low-Density Parity-Check (GLDPC) using:

- A Low-Density Parity-Check (LDPC) code as a base code, and
- Reed-Solomon (RS) codes as component codes,
  wherein RS codes are based on a quasi-Hankel matrix of the form :

$$T_q = \begin{matrix} 1 & 1 & 1 & 1 & \ldots & 1 & 1 & 1 \\ 1 & b_1 & b_2 & b_3 & \ldots & b_{q-3} & b_{q-2} & \\ 1 & b_2 & b_3 & . & \ldots & b_{q-2} & & \\ 1 & . & . & \ldots & & & & \\ . & . & . & \ldots & & & & \\ . & . & b_{q-2} & & & & & \\ 1 & b_{q-2} & & & & & & \\ 1 & & & & & & & \end{matrix}$$

where $b_i = \dfrac{1}{1-y^i}$ .  .

It is to be noted that a (n,k) code is a code of length n (which represents the number of coded symbols), and dimension k (which represents the number of information symbols).

Any square extracted matrix from Tq is invertible, so building a Maximum Distance Separable (MDS) systematic generator matrix of RS code using Tq, consists in extracting a rectangular sub-matrix of size k $\times$ (n - k) and concatenating it by identity matrix of order k.

Besides, this construction has the nice property that the first repair symbol is also equal to the direct XOR sum of the source symbols: as a consequence, a complete compatibility between the LDPC and the RS codes is reached: if extra repair symbols are not requested, repair symbols can be calculated through the LDPC code only.

According to not limited embodiments, the method can comprise one or more of the following additional characteristics:

- The method comprises decoding of coded symbols received by a receiver device, through said GLDPC code.

- The GLDPC code is adapted to generate $M_L$ repair symbols and ne=E*ML extra repair symbols, and:

- The base code is a (NL,K) LDPC code, where NL=ML+K, and

- The component codes are $M_L$ (km+1 +E, km) RS codes, where km = dm-1, dm being the degree of a row m of the binary parity-check matrix associated with the LDPC code.

- The LDPC code is a LDPC-Staircase code, and the generator matrix of a (km+1+E, km) RS code is of the form: G = [|km | A(km,1+E)] where A(km, 1+E) is a *km x (1+E)* matrix extracted from the upper triangle of Tq and $I_{km}$ is a *km x km* unit matrix. The generation of G is really simple: it is a concatenation of two matrices. No operations are needed on Tq.

In addition, there is provided an encoder adapted to carry out the provided method.
In addition, there is provided a decoder adapted to carry out the provided method.

BRIEF DESCRIPTION OF THE DRAWINGS

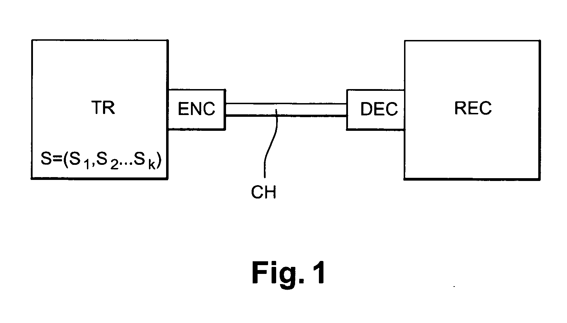

Some embodiments of base station and/or methods in accordance with embodiments of the present invention are now described, by way of example only, and with reference to the accompanying drawing, in which figure 1 schematically illustrates a block diagram of data exchanges between equipments of a network, which permits to carry out the method in accordance with the present invention.

DESCRIPTION OF EMBODIMENTS

As illustrated in figure 1, the invention relates to a method for encoding of K source symbols $S=(S_{1,S2},...,S_K)$ across a binary erasure channel CH between a transmitter device TR and a receiver device REC. Encoding is performed through an encoder ENC connected to the transmitter device TR. It is to be noted that the method is also used for decoding symbols erased by the channel, by means of a decoder DEC connected to the receiver device REC.

Encoding is performed through a (NG, K) generalized low-density parity-check (GLDPC) code adapted to generate ML repair symbols $(p_1, p_2, ..., P_{ML})$ and ne=E*ML extra repair symbols $(e_1, e_2, ..., e_{ne})$ on request. It is to be noted that E extra repair symbols are associated to each check node of the LDPC staircase. NG, K, ML and E are predetermined parameters.

The GLDPC code used for encoding uses a (NL, K) low-density parity-check (LDPC) code as a base code, where NL=ML+K. In this not limited embodiment, the LDPC code is a LDPC Staircase code. In another not limited embodiment not described, the LDPC code is a LDPC Triangular code. LDPC Staircase and LDPC Triangular codes are well-known by the person skilled in the art and described in the RFC 5170 standard.

Let $H_L$ be the binary parity-check matrix associated with the LDPC code. $H_L$ has the form $(H_1|H_2)$. $H_1$ is the *ML x K* left-hand side part (information part) and each column is of degree $N_1$ (number of "1 " per column). $H_2$ is the *ML x ML* right-hand side part (redundancy part) and features a staircase (i.e. double diagonal) structure. $H_1$ is created in a fully regular way, in order to have constant column and row degree. More precisely, each column of $H_1$ is of degree $N_1$, which is an input parameter during the LDPC Staircase code creation.

In addition, the GLDPC code is based on ML (km+1+E, km) Reed-Solomon codes as component codes, where km = dm-1, dm being the degree of a row m of the binary parity-check matrix $H_L$. In other words, the E extra-repair symbols associated to the $m^{th}$ row of $H_L$ are generated by a (km+1 +E, km) Reed-Solomon code. For row m>1, the various source symbols that are involved in this row plus the previous repair symbol, are considered as source symbols from the RS point of view. The new LDPC-Staircase repair symbol for this row plus the E extra-repair symbols are considered as repair symbols from the RS point of view. For the first row, the only difference is the fact there is no previous repair symbol.

RS codes used in the claimed method are based on quasi-Hankel matrices. Hankel matrices are square matrices whose values are constant along the descending diagonals. The construction method is based on the creation of the maximal triangular array, Bq, whose coefficients are constant along diagonals in a Hankel matrix fashion:

$$
B_q = \begin{matrix}
b_1 & b_2 & b_3 & \ldots & b_{q-2} & b_{q-1} \\
b_2 & b_3 & . & \ldots & b_{q-1} & \\
b_3 & . & . & \ldots & & \\
. & . & . & & & \\
. & . & b_{q-1} & & & \\
b_{q-2} & b_{q-1} & & & & \\
b_{q-1} & & & & &
\end{matrix}
$$

The coefficients of the triangular array are equal to $b_i = \dfrac{1}{1-y^i}$ . By using these coefficients, Bq has the property that every sub-matrix is non-singular. A quasi-Hankel matrix $T_q$ can be built by removing $b_{q-1}$ to Bq and adding an additional first row and column of 1:

$$
T_q = \begin{array}{ccccccc}
1 & 1 & 1 & 1 & \dots & 1 & 1 & 1 \\
1 & b_1 & b_2 & b_3 & \dots & b_{q-3} & b_{q-2} \\
1 & b_2 & b_3 & . & \dots & b_{q-2} \\
1 & . & . & \dots \\
. & . & . & \dots \\
. & . & b_{q-2} \\
1 & b_{q-2} \\
1
\end{array}
$$

The quasi-Hankel matrix $T_q$ does not contain any singular square sub-matrix as well. It is to be noted that the quasi-Hankel matrix $T_q$ is stored in the transmitter TR and in the receiver REC.

A generator matrix G of a (km+1+E, km) RS code can be calculated by the formula:

$$G = [I_{km} \mid A(km,1+E)],$$

where $A(km,1+E)$ is a *km x (1+E)* matrix extracted from the upper triangle of the quasi-Hankel matrix Tq.

For example, for E=2, km=4:

$$
A(4,3) = \begin{array}{ccc}
1 & 1 & 1 \\
1 & b_1 & b_2 \\
1 & b_2 & b_3 \\
1 & . & .
\end{array}, \text{ and } G = \begin{array}{ccccccc}
1 & 0 & 0 & 0 & 1 & 1 & 1 \\
0 & 1 & 0 & 0 & 1 & b_1 & b_2 \\
0 & 0 & 1 & 0 & 1 & b_2 & b_3 \\
0 & 0 & 0 & 1 & 1 & . & .
\end{array}
$$

With this technique, a systematic generator matrix is directly obtained by a trivial concatenation operation. This is a major benefit when the code needs to be produced on-the-fly.

The repair symbols $(p_1, p_2, \dots, p_{ML})$ are computed as usual, by "following the stairs" of the parity-check matrix $H_L$. Moreover, for each row m in $H_L$, the repair symbol $p_m$ is the XOR sum of the sources symbols $(x_1, \dots, x_{km})$. These symbols $(x_1, \dots, x_{km})$ are the subset $S_m$ that correspond to a 1 coefficient in row m on $H_L$. An advantage is that the repair symbol $p_m$ can be considered indifferently as an LDPC-Staircase or a RS repair symbol.

For each row m, the E extra-repair symbols $(e_1, e_2, \dots, e_E)$ are computed by multiplying the km symbols of $S_m$ plus the repair symbol $p_{m-1}$ by the systematic generator matrix G of a (km+1+E, km) RS code. An advantage of this encoding approach is the fact that extra-repair symbols can be produced incrementally, on demand, rather than all at once.

The following is an example of implementation of the invention with K=4, E=2, $N_1$=2.

$$H_L = \begin{matrix} 1 & 0 & 1 & 0 & 1 & 0 & 0 & 0 \\ 0 & 1 & 0 & 1 & 1 & 1 & 0 & 0 \\ 1 & 1 & 0 & 0 & 0 & 1 & 1 & 0 \\ 0 & 0 & 1 & 1 & 0 & 0 & 1 & 1 \end{matrix}, \text{ where } H_1 = \begin{matrix} 1 & 0 & 1 & 0 \\ 0 & 1 & 0 & 1 \\ 1 & 1 & 0 & 0 \\ 0 & 0 & 1 & 1 \end{matrix} \text{ and } H_2 = \begin{matrix} 1 & 0 & 0 & 0 \\ 1 & 1 & 0 & 0 \\ 0 & 1 & 1 & 0 \\ 0 & 0 & 1 & 1 \end{matrix}$$

As repair symbols for the LDPC Staircase code, the repair symbols $(p_1, p_2, ..., p_{ML})$ are obtained by the following calculations:

- $p_1 = XOR(s_1, s_3)$;
- $p_2 = XOR(s_2, s_4, p_1)$;
- $p_3 = XOR(s_1, s_2, p_2)$;
- $p_4 = XOR(s_3, s_4, p_3)$.

Besides, as repair symbols for the RS codes, the repair symbols $(p_1, p_2, ..., p_{ML})$ and the extra-repair symbols $(e_1, e_2, ..., e_{ne})$ are obtained by the following calculations:

- - $(s_1, s_3, p_1, e_1, e_2) = \begin{matrix} s_1 \\ s_3 \end{matrix} . G_1,$

with

$$G_1 = \begin{matrix} 1 & 0 & 1 & 1 & 1 \\ 0 & 1 & 1 & b_1 & b_2 \end{matrix}$$

- $(s_2, s_4, p_1, p_2, e_3, e_4) = \begin{matrix} s_2 \\ s_4 \\ p_1 \end{matrix} . G_2,$

with

$$G_2 = \begin{matrix} 1 & 0 & 0 & 1 & 1 & 1 \\ 0 & 1 & 0 & 1 & b_1 & b_2 \\ 0 & 0 & 1 & 1 & b_2 & b_3 \end{matrix}$$

- Etc

To conclude with, the encoding or decoding method as claimed:

- minimizes the encoding and the decoding time and limits the load in the CPU because generator matrices of RS codes are directly obtained by trivial concatenation operations;

- has capabilities very close to MDS codes performance, because each constraint node is associated to a MDS code;

- presents a complete compatibility with the LDPC. Indeed, if extra-repair symbols are not requested, the repair symbols can be computed through the LDPC code only.

**Claims**

1. A method of encoding for transmission of K source symbols ($S=(s_1,s_2,...,s_K)$) across a binary erasure channel (CH), said method comprising encoding said source symbols ($S=(s_1,s_2,...,s_K)$) by means of an encoder (ENC) connected to a transmitter device (TR), whereby encoding is performed by a (NG, K) Generalized Low-Density Parity-Check (GLDPC) using:

   - A Low-Density Parity-Check (LDPC) code as a base code, and
   - Reed-Solomon (RS) codes as component codes,
   wherein RS codes are based on a quasi-Hankel matrix of the form :

$$T_q = \begin{matrix} 1 & 1 & 1 & 1 & ... & 1 & 1 & 1 \\ 1 & b_1 & b_2 & b_3 & ... & b_{q-3} & b_{q-2} & \\ 1 & b_2 & b_3 & . & ... & b_{q-2} & & \\ 1 & . & . & ... & & & & \\ . & . & . & ... & & & & \\ . & . & b_{q-2} & & & & & \\ 1 & b_{q-2} & & & & & & \\ 1 & & & & & & & \end{matrix}$$

   where $b_i = \dfrac{1}{1-y^i}$ .     .

2. A method according to any of previous claims, wherein the Generalized Low-Density Parity-Check (GLDPC) code is adapted to generate ML repair symbols ($p_1,p_2,...,p_{ML}$) and ne=E*ML extra repair symbols ($e_1,e_2,...,e_{ne}$), and:

   - The base code is a (NL,K) LDPC code, where NL=ML+K, and
   - The component codes are ML (km+1 +E, km) RS codes, where km = dm-1, dm being the degree of a row m of the binary parity-check matrix ($H_L$) associated with the LDPC code.

3. A method according to the previous claim, wherein the base code is a LDPC-Staircase code, and the generator matrix (G) of a (km+1+E, km) RS code is of the form: G = [$I_{km}$ | A(km,1 +E)] where A(km,1 +E) is a km x (1+E) matrix extracted from the upper triangle of the quasi-Hankel matrix (Tq).

4. A method according to claim any of previous claims, comprising decoding, by means of a decoder (DEC), of coded symbols received by a receiver device (REC), wherein decoding is performed using said GLDPC code.

5. An encoder (ENC) adapted to carry out a method according to any of the previous claims.

6. A decoder (DEC) adapted to carry out a method according to claim 4.

**Fig. 1**

Europäisches
Patentamt

European
Patent Office

Office européen
des brevets

# EUROPEAN SEARCH REPORT

Application Number

EP 12 17 2196

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | MATHIEU CUNCHE ET AL: "Low-rate coding using incremental redundancy for GLDPC codes", SATELLITE AND SPACE COMMUNICATIONS, 2008. IWSSC 2008. IEEE INTERNATIONAL WORKSHOP ON, IEEE, PISCATAWAY, NJ, USA, 1 October 2008 (2008-10-01), pages 299-303, XP031352194, ISBN: 978-1-4244-1947-0 * the whole document * ----- | 1-6 | INV. H03M13/37 |
| Y | ROTH R M ET AL: "On generator matrices of MDS codes (Corresp.)", IEEE TRANSACTIONS ON INFORMATION THEORY, IEEE PRESS, USA, vol. 31, no. 6, 1 November 1985 (1985-11-01), pages 826-830, XP011423242, ISSN: 0018-9448, DOI: 10.1109/TIT.1985.1057113 * the whole document * ----- | 1-6 | |
| Y | Mathieu Cunche: "Codes AL-FEC hautes performances pour les canaux à effacements :variations autour des codes LDPC", TEL (thèses-en-ligne) online repository , 30 June 2010 (2010-06-30), XP002684741, Retrieved from the Internet: URL:http://tel.archives-ouvertes.fr/docs/00/49/65/06/PDF/these.pdf [retrieved on 2012-10-05] * page 33 - page 46 * * page 111 - page 122 * ----- -/-- | 1-6 | TECHNICAL FIELDS SEARCHED (IPC) H03M |

The present search report has been drawn up for all claims

| Place of search | Date of completion of the search | Examiner |
|---|---|---|
| The Hague | 8 October 2012 | Belardinelli, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 12 17 2196

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | V. Olshevsky, M. Amin Shokrollahi: "A displacement approach to decoding algebraic codes", CiteseerX , vol. Contemporary mathematics 18 August 2000 (2000-08-18), pages 265-292, XP002684742, Boston, Ma, US ISBN: 0-8218-3177-1 Retrieved from the Internet: URL:http://citeseerx.ist.psu.edu/viewdoc/download?doi=10.1.1.131.9918&rep=rep1&type=pdf [retrieved on 2012-10-04] * the whole document * ----- | 1-6 | |
| A | WO 2006/099517 A2 (TANDBERG DATA CORP [US]; DICKSON LAWRENCE JOHN [US]) 21 September 2006 (2006-09-21) * claim 1 * ----- | 1,4-6 | |

TECHNICAL FIELDS
SEARCHED (IPC)

The present search report has been drawn up for all claims

| Place of search | Date of completion of the search | Examiner |
|---|---|---|
| The Hague | 8 October 2012 | Belardinelli, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

..........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 12 17 2196

This annex lists the patent family members relating to the patent documents cited in the above-mentioned European search report.
The members are as contained in the European Patent Office EDP file on
The European Patent Office is in no way liable for these particulars which are merely given for the purpose of information.

08-10-2012

| Patent document cited in search report | Publication date | Patent family member(s) | | Publication date |
|---|---|---|---|---|
| WO 2006099517 A2 | 21-09-2006 | EP | 1859452 A2 | 28-11-2007 |
| | | US | 2006218470 A1 | 28-09-2006 |
| | | WO | 2006099517 A2 | 21-09-2006 |

EPO FORM P0459

For more details about this annex : see Official Journal of the European Patent Office, No. 12/82

## REFERENCES CITED IN THE DESCRIPTION

**Non-patent literature cited in the description**

- **TANNER.** A recursive approach to low complexity codes. *IEEE Transactions on Information Theory,* September 1981, vol. 27 (5), 533-547

- **M. CUNCHE.** Low-rate coding using incremental redundancy for GLDPC codes. *IEEE International Workshop on Satellite and Space Communications,* October 2008, 299-303